# EUROPÄISCHE PATENTSCHRIFT

(11) **EP 3 539 214 B1**
(45) Veröffentlichungstag und Bekanntmachung des Hinweises auf die Patenterteilung: **05.01.2022**
(21) Anmeldenummer: 17804061.4
(22) Anmeldetag: 13.11.2017
(51) Int. Cl.: H03K 17/0424

(54) **VORRICHTUNG UND VERFAHREN ZUR SELBSTVERSTÄRKENDEN ANSTEUERUNG EINES LADUNGSGESTEUERTEN SCHALTELEMENTS SOWIE VERWENDUNG EINES TRANSFORMATORS**
DEVICE AND METHOD FOR THE SELF-REINFORCING ACTUATION OF A CHARGE-CONTROLLED SWITCHING ELEMENT, AND USE OF A TRANSFORMER
DISPOSITIF ET PROCÉDÉ DE COMMANDE D'AUTO-AMPLIFICATION D'UN ÉLÉMENT DE COMMUTATION À COMMANDE DE CHARGE ET UTILISATION D'UN TRANSFORMATEUR

(30) Priorität: 14.11.2016 DE 102016222268
(43) Veröffentlichungstag der Anmeldung: 18.09.2019
(73) Patentinhaber: Technische Universität Dortmund, 44227 Dortmund (DE)
(72) Erfinder: EBLI, Michael, 44263 Dortmund (DE); PFOST, Martin, 72762 Reutlingen (DE)
(74) Vertreter: Michalski Hüttermann & Partner Patentanwälte mbB
(86) Internationale Anmeldenummer: PCT/EP2017/001318
(87) Internationale Veröffentlichungsnummer: WO 2018/086745

(56) Entgegenhaltungen:
- DE-A1- 3 644 777
- DE-B1- 2 916 105
- JP-A- S6 062 230
- US-A1- 2014 306 739
- SZABO B A: "Reduction of Turn-On and Turn-Off Time of Transistors by Differentiated Feedback", SOLID/STATE/DESIGN,, Bd. 5, Nr. 3, 1. März 1964 (1964-03-01), Seite 11, XP001618528,

## Beschreibung

Die Erfindung betrifft eine Schaltungsvorrichtung und ein Verfahren zur selbstverstärkenden Ansteuerung eines ladungsgesteuerten Schaltelements. Ferner betrifft die Erfindung eine Verwendung eines Transformators.

Die Effizienz von elektrischen bzw. ladungsgesteuerten Schaltern bzw. Schaltwandlern wird maßgeblich durch Verluste während des Schaltvorgangs bestimmt. Dies trifft vor allem für Leistungsschalter zu. Um solche Verluste zu reduzieren, ist es wünschenswert, möglichst schnell zu schalten, d.h. den Schaltvorgang zu beschleunigen bzw. die Schaltzeit zu verkürzen. Jedoch ist die Schaltgeschwindigkeit, insbesondere von Leistungsschaltern, auf Grund von parasitären Effekten begrenzt.

Galliumnitrid (GaN) Leistungstransistoren stellen z.B. unipolare Bauteile bzw. Schaltelemente ohne Minoritätsladungsträgerspeicher und sehr kleinen parasitären Kapazitäten dar. Folglich sind sehr schnelle Schaltvorgänge möglich. Jedoch ist auch bei solchen GaN Leistungstransistoren die Schaltgeschwindigkeit auf Grund von parasitären Elementen, insbesondere durch parasitäre Induktivitäten wie z.B. die "Common-Source" Induktivität, begrenzt. Die "Common-Source" Induktivität induziert eine Spannung entgegen der Gate-Source Spannung des Transistors, was den Einschaltvorgang verlangsamt.

Bisherige Lösungen zur Erhöhung der Schaltgeschwindigkeit zielen insbesondere darauf ab, die parasitären Effekte zu reduzieren. So kann z.B. die "Common-Source" Induktivität durch eine monolithische Integration des Gate-Treibers mit dem Leistungstransistor minimiert werden. Eine andere Lösung besteht darin, die an das Gate eines Transistors angelegte Gate-Spannung temporär zu erhöhen. Auf diese Weise kann die Aufladezeit der parasitären Eingangskapazität, beispielsweise eines Silizium IGBTs ("insulated-gate bipolar transistor"), reduziert und somit die Schaltgeschwindigkeit erhöht werden. Insbesondere nutzen bisherige Ansätze zur Erhöhung der Schaltgeschwindigkeit zusätzliche Spannungsquellen mit erhöhter bzw. überhöhter Gate-Spannung, welche durch zusätzliche Schalter zeitweise zugeschaltet werden. Die temporär am Gate des Transistors angelegte Gesamtspannung kann somit höher als die spezifizierte bzw. zulässige statische Steuerspannung sein und das Einschalten des Transistors beschleunigen.

Diese bisherigen Lösungen können zwar zu reduzierten Schaltzeiten eines ladungsgesteuerten Schalters bzw. Transistors führen, jedoch sind damit auch diverse Nachteile verbunden. Die oben genannte erste Lösung (monolithische Integration) ist z.B. relativ kostspielig und nur auf ganz spezifische Technologien anwendbar. Die oben genannte zweite Lösung (temporäres Erhöhen der Gate-Spannung) benötigt ein sehr genaues Timing, d.h. sie stellt hohe Anforderungen an die zeitliche Auflösung und an die Genauigkeit der Steuereinheit bzw. des Gate-Treibers, da mit einer Zusatzspannung gearbeitet wird, die über einer vom Hersteller des Schalters spezifizierten Gate-Spannung liegt. Nur durch eine präzise Kontrolle bzw. Steuerung kann eine Schädigung des Halbleiters vermieden werden. Ein Fehler bzw. eine Fehlfunktion des Gate-Treibers kann dagegen zur Zerstörung des Halbleiters führen, insbesondere dann, wenn eine überhöhte Gate-Source Spannung, d.h. eine Gate-Source Spannung, die über der spezifizierten Gate-Source Spannung liegt, über einen zu langen Zeitraum angelegt wird.

Weitere Lösungen sind von Dokumenten US 2014/306739 A1 und DE 36 44 777 A1 bekannt.

Es ist daher eine Aufgabe der vorliegenden Erfindung, eine Vorrichtung und ein Verfahren zum schnellen Schalten eines ladungsgesteuerten Schaltelements bereitzustellen, welche/welches einfach, effektiv und kostengünstig ist.

Diese Aufgabe wird durch die Gegenstände der nebengeordneten Ansprüche gelöst. Vorteilhafte Ausführungsformen sind Gegenstand der Unteransprüche.

Sofern nichts anderes angegeben ist, wird im Rahmen der vorliegenden Beschreibung unter dem Begriff "Verbinden" stets ein elektrisches Verbinden verstanden.

Ein erster unabhängiger Aspekt zur Lösung der Aufgabe betrifft eine Schaltungsvorrichtung umfassend:
- ein ladungsgesteuertes Schaltelement mit einem ersten Laststromanschluss für den Zufluss eines zu schaltenden Laststroms, einen zweiten Laststromanschluss für den Abfluss des zu schaltenden Laststroms und einen Steueranschluss zum Steuern des Schaltelements mittels eines Steuersignals, wobei der erste und der zweite Laststromanschluss in einem Laststrompfad der Schaltungsvorrichtung integriert sind und wobei der Steueranschluss in einem Steuerstrompfad der Schaltungsvorrichtung integriert ist;
- eine Steuereinheit zum Bereitstellen des Steuersignals; und
- ein Kopplungselement zum galvanisch getrennten Übertragen von Energie aus dem Laststrompfad in den Steuerstrompfad.

Unter einer "Schaltungsvorrichtung" wird im Sinne der Erfindung eine elektrische Schaltung bzw. ein elektrischer Schaltkreis verstanden. Unter einem "ladungsgesteuerten Schaltelement" wird ein elektrischer Schalter, insbesondere ein Halbleiterschalter bzw. ein Transistor, verstanden, welcher über eine Ladung gesteuert, d.h. ein- und ausgeschaltet werden kann. Das Schaltelement kann also elektrisch, d.h. insbesondere mit Hilfe einer Spannung oder eines Stroms gesteuert bzw. geschaltet werden. Das elektrisch gesteuerte bzw. ladungsgesteuerte Schaltelement kann daher z.B. ein spannungsgesteuertes oder stromgesteuertes Schaltelement sein.

Das ladungsgesteuerte Schaltelement kann z.B. ein Halbleiter bzw. ein Halbleiterschalter und insbesondere ein Transistor sein. Grundsätzlich kann das ladungsgesteuerte Schaltelement jegliche Art eines elektrisch gesteuerten Schalters bzw. Transistors darstellen. Beispielsweise kann das Schaltelement ein Bipolartransistor oder ein Feldeffekt-Transistor (FET) sein. Das ladungsgesteuerte Schaltelement kann insbesondere ein Bipolartransistor mit isolierter Gate-Elektrode (IGBT) oder ein High-electron-mobility transistor (HEMT) sein, um nur zwei willkürlich gewählte Beispiele zu nennen. Insbesondere handelt es sich bei dem ladungsgesteuerten Schaltelement um einen Leistungsschalter bzw. Leistungstransistor bzw. Leistungshalbleiter.

Das ladungsgesteuerte Schaltelement weist zumindest drei verschiedene Anschlüsse auf, nämlich einen ersten und zweiten Laststromanschluss sowie einen Steueranschluss. Allgemein wird unter dem Begriff "Anschluss" eine Elektrode des Schaltelements verstanden. An die Laststromanschlüsse kann ein Verbraucher oder eine Last angeschlossen werden, welcher/welche über das Schaltelement gesteuert bzw. geschaltet werden kann. Über den Steueranschluss kann ein Laststrom, welcher durch den Schalter bzw. durch einen Verbraucher fließt, geregelt bzw. elektrisch gesteuert werden. Dabei umfasst der Begriff "Steuern" insbesondere ein Ein- und Ausschalten bzw. ein Aktivieren und Deaktivieren. Mit anderen Worten kann das Schaltelement durch Aufbringen einer bestimmten Ladung bzw. durch Anlegen einer bestimmten Spannung an den Steueranschluss des Schaltelements elektrisch leitend oder isolierend geschaltet werden.

Im Falle eines Bipolartransistors kann der erste Laststromanschluss z.B. ein Emitter oder Kollektor sein. Im Fall eines Feldeffekt-Transistors kann dieser erste Laststromanschluss z.B. ein Source- oder Drain-Anschluss sein. Der zweite Laststromanschluss des ladungsgesteuerten Schaltelements kann im Fall eines Bipolartransistors entsprechend ein Kollektor oder Emitter und im Fall eines Feldeffekt-Transistors entsprechend ein Drain- oder Source-Anschluss sein. Beispielsweise ist der erste Laststromanschluss ein Drain-Anschluss und der zweite Laststromanschluss ein Source-Anschluss. Weiter beispielsweise ist der erste Laststromanschluss ein Emitter und der zweite Laststromanschluss ein Kollektor. Der Steueranschluss kann z.B. im Fall eines Bipolartransistors ein Basis-Anschluss und im Fall eines Feldeffekt-Transistors ein Gate-Anschluss sein. Insbesondere ist bei Leistungsschalter bzw. Leistungs-FET der Source-Anschluss mit einem Bulk Anschluss verbunden.

Der erste und der zweite Laststromanschluss sind in einem Laststrompfad bzw. Laststromkreis der Schaltungsvorrichtung integriert. Mit anderen Worten sind der erste und der zweite Laststromanschluss Bestandteile eines Laststrompfades. Insbesondere sind der erste und der zweite Laststromanschluss mit dem Laststrompfad verbunden. Durch den Laststrompfad bzw. im Laststromkreis fließt im leitenden Zustand des Schaltelements ein Laststrom. Beispielsweise kann der Laststrompfad bzw. der Laststromkreis eine Lastkreis-Spannungsquelle, eine Last sowie den ersten und zweiten Laststromanschluss umfassen. Insbesondere kann der Laststrompfad bzw. der Laststromkreis als ein Strompfad bzw. Stromkreis ausgebildet sein, der eine Lastkreis-Spannungsquelle, eine Last sowie den ersten und zweiten Laststromanschluss des Schaltelements miteinander verbindet. Mit anderen Worten kann der Laststrompfad eine elektrische Verbindung bzw. Verdrahtung einer Lastkreis-Spannungsquelle mit einer Last und dem ersten und zweiten Laststromanschluss des Schaltelementes umfassen bzw. dadurch ausgebildet sein. Insbesondere ist die Lastkreis-Spannungsquelle mit dem ersten Laststromanschluss und die Last mit dem zweiten Laststromanschluss verbunden.

Der Steueranschluss ist in einem Steuerstrompfad bzw. Steuerstromkreis oder Gatestromkreis der Schaltungsvorrichtung integriert. Mit anderen Worten ist der Steueranschluss ein Bestandteil des Steuerstrompfades. Insbesondere ist der Steueranschluss mit dem Steuerstrompfad verbunden. Der Steuerstrompfad bzw. Steuerkreis dient zum Steuern des Schaltelements. Beispielsweise kann der Steuerstrompfad bzw. der Steuerstromkreis die Steuereinheit bzw. einen Gate-Treiber und den Steueranschluss des Schaltelements umfassen. Mit anderen Worten kann der Steuerstrompfad eine elektrische Verbindung bzw. Verdrahtung der Steuereinheit mit dem Steueranschluss des Schaltelementes umfassen bzw. dadurch ausgebildet sein. Insbesondere ist die Steuereinheit mit dem Steueranschluss des Schaltelements verbunden. Die Steuereinheit kann zumindest eine schaltbare Steuer-Spannungsquelle zum Bereitstellen einer Steuerspannung umfassen. Insbesondere kann die Steuereinheit zumindest eine Spannungsquelle und einen oder mehrere Steuerschalter umfassen. Vorzugsweise umfasst die Steuereinheit einen Standard Gate-Treiber.

Die Steuereinheit der Schaltungsvorrichtung stellt das Steuersignal bereit. Mit Hilfe der Steuereinheit kann das Schaltelement gesteuert, d.h. ein und ausgeschaltet bzw. leitend und isolierend geschaltet werden. Die Steuereinheit ermöglicht insbesondere ein statisches Einschalten des Schaltelements.

Schließlich weist die Schaltungsvorrichtung noch ein Kopplungselement zum galvanisch getrennten Übertragen von Energie bzw. einer Ladung, einer Spannung und/oder eines Stroms aus dem Laststrompfad in den Steuerstrompfad auf. Das Kopplungselement ist ein induktives Kopplungselement. Mit anderen Worten kann die Kopplung bzw. Rückkopplung von Energie des Laststrompfades in den Steuerstrompfad induktiv erfolgen. Unter einer galvanischen Trennung oder galvanischen Entkopplung wird allgemein das Vermeiden von elektrischen Leitungen zwischen zwei Strompfaden bzw. Stromkreisen, zwischen denen Leistung oder Signale ausgetauscht werden sollen, verstanden. Anstelle einer elektrischen Leitung wird das Kopplungselement verwendet.

Mit der erfindungsgemäßen Schaltvorrichtung, insbesondere durch die galvanisch entkoppelte Übertragung von Energie aus dem Laststrompfad in den Steuerstrompfad, kann das Steuersignal, beispielsweise ein Steuerstrom und/oder eine Steuerspannung, erhöht werden, so dass sich dadurch vorteilhafterweise auch die Schaltgeschwindigkeit des Schaltelements erhöht. Durch die Verkürzung der Schaltzeit können auch Schaltverluste reduziert werden. Zudem kann zur Ansteuerung des Schaltelements ein einfacher Standard Gate-Treiber verwendet werden, so dass aufwendige Schaltungen zur Sicherstellung des richtigen Timings vorteilhafterweise entfallen. Die erfindungsgemäße Schaltvorrichtung bietet somit eine einfache, effektive und kostengünstige Lösung für ein schnelles Schalten eines elektrischen bzw. ladungsgesteuerten Schaltelements. Insbesondere eignet sich die erfindungsgemäße Schaltvorrichtung als schneller Schalter für alle hartschaltenden Anwendungen.

Der Transformator ist derart ausgelegt und angeordnet, dass er bei einem Einschaltvorgang des Schaltelements eine zusätzliche Spannung am Steueranschluss des Schaltelements bereitstellt, um somit das Steuersignal zu erhöhen. Somit ist vorteilhafterweise ein schnelleres Schalten möglich.

In einer weiteren bevorzugten Ausführungsform ist die Sekundärspule zwischen der Steuereinheit und dem Steueranschluss des Schaltelements geschaltet. Die Sekundärspule kann entweder in Reihe mit der Steuereinheit geschaltet sein oder die Sekundärspule kann parallel zu der Steuereinheit geschaltet sein. Im letzteren Fall weist die Schaltvorrichtung vorzugsweise zusätzlich eine Diode auf, welche in Reihe mit der Sekundärspule und somit ebenfalls parallel zu der Steuereinheit geschaltet ist.

Das Kopplungselement ist ein Transformator mit einer Primärspule und einer Sekundärspule. Das Koppeln bzw. Übertragen von Energie aus dem Laststrompfad in den Steuerstrompfad erfolgt somit vorzugsweise induktiv. Der Transformator ist insbesondere derart ausgelegt und angeordnet, dass bei einem Einschaltvorgang des Schaltelements am Steueranschluss des Schaltelements eine zusätzliche Spannung anliegt. Der Transformator verhält sich während des Einschaltvorgangs des Schaltelements also wie eine zusätzliche Spannungsquelle, wodurch sich ein Steuersignal bzw. ein Steuerstrom erhöht. Somit kann die Schaltgeschwindigkeit des Schaltelements vorteilhafterweise erhöht werden.

Der Transformator ist vorzugsweise ein Luft-Transformator. Da ein Luft-Transformator kein Kernmaterial aufweist, sind die Verluste bei einem Luft-Transformator vorteilhafterweise geringer als bei einem Transformator mit Kern.

In einer weiteren bevorzugten Ausführungsform ist die Primärspule des Transformators mit einem der beiden Laststromanschlüssen, insbesondere mit dem zweiten Laststromanschluss des Schaltelements, verbunden. Zusätzlich ist die Sekundärspule des Transformators mit dem Steueranschluss des Schaltelements verbunden.

Insbesondere ist die Primärspule derart im Laststrompfad bzw. Laststromkreis integriert bzw. angeordnet, dass durch die Primärspule der zu schaltende Laststrom fließt. Auf diese Weise wird beim Einschaltvorgang des Schaltelements, bei dem sich der Laststrom ändert, ein Magnetfeld in der Primärspule erzeugt. Das sich aufbauende Magnetfeld bzw. die damit verbundene magnetische Flussänderung induziert schließlich in der Sekundärspule eine Spannung.

Während des Einschaltvorgangs wird somit in der Sekundärspule des Transformators eine Spannung induziert, welche zur Steuerung des Schaltelements, d.h. dem Steueranschluss des Schaltelements, zusätzlich zur Verfügung gestellt werden kann. Damit kann der Schaltvorgang beschleunigt werden. Die Höhe der induzierten Spannung in der Sekundärspule hängt dabei von der Änderung des Stroms, welcher durch die Primärspule fließt, ab. Insbesondere ist die induzierte Spannung direkt proportional zu der Änderung des Stroms durch die Primärspule, d.h. zu der Laststromänderung. Somit ist die durch den Transformator bewirkte Kopplung selbstenergetisch bzw. selbstverstärkend, da mit ansteigendem Steuer- bzw. Gatestrom auch die Laststromänderung zunimmt. Vorteilhafterweise kann die induktive Kopplung, insbesondere deren Stärke, über die geometrische Form des Transformators, beispielsweise über die Windungszahl von Primär- und Sekundärspule, und/oder über die Schleifenfläche verändert bzw. eingestellt werden.

In einer weiteren bevorzugten Ausführungsform umfasst die Schaltungsvorrichtung bzw. dessen Steuereinheit eine Spannungsquelle. Die Spannungsquelle dient insbesondere zum Bereitstellen einer Steuerspannung für den Steueranschluss des Schaltelements und kann somit auch als Steuer-Spannungsquelle bezeichnet werden. Alternativ oder zusätzlich umfasst die Schaltungsvorrichtung einen Standard Gate-Treiber. Die Spannungsquelle und/oder der Standard Gate-Treiber sind vorzugsweise über die Sekundärspule des Transformators mit dem Steueranschluss des Schaltelements verbunden. Die Spannungsquelle ist insbesondere ein Bestandteil des Gate-Treibers.

In einer weiteren bevorzugten Ausführungsform ist die Steuereinheit galvanisch mit dem Steueranschluss des Schalters verbunden. Unter einer galvanischen Verbindung wird im Sinne dieser Beschreibung insbesondere eine Verbindung mittels elektrischer Leiter verstanden. Insbesondere ist die Spannungsquelle und/oder der Gate-Treiber galvanisch mit dem Schaltelement bzw. dessen Steueranschluss verbunden. Und insbesondere ist die Steuereinheit bzw. die Spannungsquelle und/oder der Standard Gate-Treiber galvanisch über die Sekundärspule des Transformators mit dem Steueranschluss des Schaltelements verbunden. Auf diese Weise ist eine statische Ansteuerung und insbesondere ein statisches bzw. dauerhaftes Ein- und Ausschalten des Schaltelements möglich.

In einer weiteren bevorzugten Ausführungsform umfasst die Schaltungsvorrichtung ferner einen einstellbaren Deaktivierungswiderstand oder einen Deaktivierungsschalter zum Deaktivieren (und Aktivieren) der induktiven Kopplung. Mit Hilfe des Deaktivierungswiderstands bzw. Deaktivierungsschalters kann vorteilhafterweise die induktive Kopplung zeitlich variiert werden. Beispielsweise kann die induktive Kopplung beim Ausschalten anders als beim Einschalten gestaltet werden.

Der Deaktivierungswiderstand bzw. der Überbrückungsschalter kann z.B. in Serie zur Sekundärspule geschaltet sein. Vorzugsweise ist der einstellbare Deaktivierungswiderstand bzw. der Deaktivierungsschalter parallel zur Sekundärspule des Transformators geschaltet und kann so zum Überbrücken der Sekundärspule dienen. Der einstellbare Deaktivierungswiderstand kann somit ein einstellbarer Überbrückungswiderstand sein und der Deaktivierungsschalter kann ein Überbrückungsschalter sein. Mit Hilfe des Überbrückungsschalters oder des Überbrückungswiderstands kann die Sekundärspule überbrückt bzw. kurzgeschlossen werden. Auf diese Weise ist es möglich, die induktive Kopplung zu aktivieren und zu deaktivieren. Wird der Überbrückungsschalter geschlossen oder der Widerstandswert des einstellbaren Widerstands unter einen vorgegebenen ersten Schwellwert verringert, so wird die Sekundärspule kurzgeschlossen und somit die induktive Kopplung deaktiviert. Durch Öffnen des Überbrückungsschalters oder durch Erhöhen des Widerstandswertes des einstellbaren Widerstands über einen vorgegebenen zweiten Schwellwert kann die induktive Kopplung wieder aktiviert werden.

Im Rahmen der vorliegenden Erfindung hat sich gezeigt, dass die Schaltungsvorrichtung beim Ausschaltvorgang mit einer aktiven Rückkopplung zu schwingen anfängt. Mit Hilfe des Überbrückungsschalters kann die Kopplung während des Ausschaltvorgangs deaktiviert werden, so dass vorteilhafterweise das Schwingen verhindert werden kann.

Alternativ oder zusätzlich umfasst die Schaltungsvorrichtung ferner einen externen Einschaltwiderstand, der zwischen der Sekundärspule des Transformators und dem Steueranschluss des Schalters angeordnet bzw. geschaltet ist. Mit dem Begriff "extern" soll angedeutet werden, dass es sich um ein zusätzliches Bauteil und nicht um einen inneren Widerstand handelt. Der externe Einschaltwiderstand kann z.B. ein Gate-Vorwiderstand sein.

In einer weiteren bevorzugten Ausführungsform umfasst der Steuerstrompfad einen Einschaltepfad, über den ein Einschalten des Schaltelements erfolgt, und einen Ausschaltepfad, über den ein Ausschalten des Schaltelements erfolgt. Dabei umfasst der Einschaltepfad vorzugsweise die Sekundärspule des Transformators. Es ist grundsätzlich auch möglich, dass der Ausschaltepfad die Sekundärspule umfasst oder dass sowohl der Einschaltepfad als auch der Ausschaltepfad jeweils eine Sekundärspule umfassen. Der Einschaltepfad kann zudem einen ersten Steuerschalter umfassen. Entsprechen kann der Ausschaltepfad ferner einen zweiten Steuerschalter umfassen. Vorteilhafterweise kann dadurch ein sicheres Ausschalten des Schaltelements über den separaten Ausschaltepfad, welcher die Sekundärspule des Transformators nicht umfasst, gewährleistet werden.

Vorzugsweise umfasst der Einschaltepfad einen externen Einschaltwiderstand. Entsprechend umfasst vorzugsweise der Ausschaltepfad einen externen Ausschaltwiderstand. Der externe Einschaltwiderstand ist vorzugsweise größer als der externe Ausgangswiderstand. Beispielsweise kann der externe Einschaltwiderstand 8 Ohm betragen, während der externe Ausschaltwiderstand zwischen 0 und 8 Ohm betragen kann. Es versteht sich, dass je nach Anwendung auch andere Werte möglich sind.

In einer weiteren bevorzugten Ausführungsform stellt das Kopplungselement einen integralen Bestandteil einer Leiterplatte bzw. Platine dar. Insbesondere kann die induktive Kopplung allein durch eine geeignete Leitungsführung auf der Platine realisiert sein. Vorzugsweise ist die gesamte Schaltvorrichtung auf einer Leiterplatte realisiert. Dies führt vorteilhafterweise zu einer besonders kostengünstigen Implementierung der erfindungsgemäßen Schaltungsvorrichtung. Vorzugsweise ist die erfindungsgemäße Schaltvorrichtung auf einer Leiterplatte, welche mehrere Ebenen oder Schichten aufweist, mit Hilfe des sogenannten "Strip line" Konzeptes implementiert bzw. realisiert. Das "Strip line" Konzept ist insbesondere durch eine Leitungsführung derart charakterisiert, dass der Strom auf einer Ebene oder Schicht der Leiterplatte hin und auf einer anderen Ebene oder Schicht der Leiterplatte zurück fließt. Durch das Verwenden des "Strip line" Konzeptes können parasitäre Effekte, beispielsweise parasitäre Induktivitäten, reduziert und somit die Schaltgeschwindigkeit des Schaltelements weiter erhöht werden.

Ein weiterer unabhängiger Aspekt zur Lösung der Aufgabe betrifft ein Verfahren zur selbstverstärkenden Ansteuerung eines ladungsgesteuerten Schaltelements, umfassend:
- Bereitstellen des ladungsgesteuerten Schaltelements mit einem ersten Laststromanschluss für den Zufluss eines zu schaltenden Laststroms, einem zweiten Laststromanschluss für den Abfluss des zu schaltenden Laststroms und einem Steueranschluss zum Steuern des Schaltelements, wobei der erste und der zweite Laststromanschluss in einen Laststrompfad und der Steueranschluss in einen Steuerstrompfad integriert wird;
- Steuern des ladungsgesteuerten Schaltelements mit Hilfe einer Steuereinheit; und
- galvanisch getrenntes Übertragen von Energie aus dem Laststrompfad in den Steuerstrompfad während eines Einschaltvorgangs des Schaltelements mit Hilfe eines Kopplungselements.

Insbesondere ist der erste und der zweite Laststromanschluss des Schaltelements mit dem Laststrompfad verbunden. Entsprechend ist insbesondere der Steueranschluss des Schaltelements mit einem Steuerstrompfad verbunden.

Vorzugsweise wird bei dem erfindungsgemäßen Verfahren die erfindungsgemäße Schaltungsvorrichtung bereitgestellt.

Durch das erfindungsgemäße Verfahren, insbesondere durch das galvanisch getrennte Übertragen von Energie aus dem Laststrompfad in den Steuerstrompfad während des Einschaltvorgangs, kann der Einschaltvorgang vorteilhafterweise in einfacher, effizienter und kostengünstiger Weise beschleunigt werden.

Das Kopplungselement ist ein Transformator mit einer Primärspule und einer Sekundärspule. Das Steuern des Schaltelements umfasst vorzugsweise ein Ein- und Ausschalten des Schaltelements, wobei das Einschalten über einen Einschaltepfad und das Ausschalten über einen Ausschaltepfad des Steuerstrompfads erfolgt. Dabei umfasst vorzugsweise der Einschaltepfad die Sekundärspule des Transformators.

Das Verfahren ferner umfasst ein Deaktivieren der Sekundärspule des Transformators bzw. der durch den Transformator bewirkten induktiven Kopplung während eines Ausschaltvorgangs des Schaltelements. Vorzugsweise erfolgt das Deaktivieren der Sekundärspule durch ein elektrisches Überbrücken der Sekundärspule.. Das elektrische Überbrücken kann z.B. mit Hilfe eines Deaktivierungsschalters bzw. Überbrückungsschalters oder mit Hilfe eines einstellbaren Widerstands erfolgen. Der Überbrückungsschalter oder der einstellbare Widerstand kann parallel zur Sekundärspule geschaltet werden. Durch das Überbrücken der Sekundärspule, d.h. durch ein Schließen des Überbrückungsschalters oder durch ein Verringern des Widerstandswertes des einstellbaren Widerstands, kann die Sekundärspule bzw. die induktive Kopplung deaktiviert werden. Mit anderen Worten kann dadurch die Wirkung der induktiven Kopplung unterdrückt werden. Somit kann die induktive Kopplung beim Ausschalten anders als beim Einschalten gestaltet werden. Insbesondere kann also die Kopplung während des Ausschaltvorgangs deaktiviert werden, so dass vorteilhafterweise ein störendes Schwingen der Schaltung verhindert werden kann.

In einer weiteren bevorzugten Ausführungsform des erfindungsgemäßen Verfahrens wird das Schaltelement mit einem Standard Gate-Treiber gesteuert. Mit anderen Worten umfasst oder ist die Steuereinheit ein Standard Gate-Treiber. Insbesondere werden der Einschaltvorgang und der Ausschaltvorgang des Schaltelements mit Hilfe des Standard Gate-Treibers initiiert bzw. gesteuert. Vorteilhafterweise sind bei dem erfindungsgemäßen Verfahren keine aufwendigen Schaltungen oder spezielle Gate-Treiber zur Sicherstellung eines richtigen Timings hinsichtlich der Zuschaltung einer zusätzlichen Steuerspannung notwendig.

Ein weiterer unabhängiger Aspekt zur Lösung der Aufgabe betrifft die Verwendung eines Transformators zur selbstverstärkenden Ansteuerung eines ladungsgesteuerten bzw. spannungsgesteuerten Schaltelements.

In einer bevorzugten Ausführungsform ist der Transformator Bestandteil einer Schaltungsvorrichtung und wird derart ausgelegt und angeordnet, dass während eines Einschaltvorgangs des Schaltelements Energie aus einem Laststrompfad der Schaltungsvorrichtung in einen Steuerstrompfad der Schaltungsvorrichtung übertragen wird. Das Schaltelement ist sowohl in dem Laststrompfad als auch in dem Steuerstrompfad integriert.

In einer weiteren bevorzugten Ausführungsform wird eine Primärspule des Transformators mit einem Laststromanschluss des Schaltelements verbunden. Insbesondere wird die Primärspule derart mit einem Laststromanschluss des Schaltelements verbunden, dass ein zu schaltender Laststrom durch die Primärspule fließt. Zudem wird eine Sekundärspule des Transformators mit einem Steueranschluss des Schaltelements verbunden.

Für die oben genannten weiteren unabhängigen Aspekte und insbesondere für diesbezügliche bevorzugte Ausführungsformen gelten auch die vor- oder nachstehend gemachten Ausführungen zu den Ausführungsformen des ersten Aspekts. Insbesondere gelten für einen unabhängigen Aspekt der vorliegenden Erfindung und für diesbezügliche bevorzugte Ausführungsformen auch die vor- und nachstehend gemachten Ausführungen zu den Ausführungsformen der jeweils anderen unabhängigen Aspekte.

Im Folgenden werden einzelne Ausführungsformen zur Lösung der Aufgabe anhand der Figuren beispielhaft beschrieben. Dabei weisen die einzelnen beschriebenen Ausführungsformen zum Teil Merkmale auf, die nicht zwingend erforderlich sind, um den beanspruchten Gegenstand auszuführen, die aber in bestimmten Anwendungsfällen gewünschte Eigenschaften bereitstellen. So sollen auch Ausführungsformen als unter die beschriebene technische Lehre fallend offenbart angesehen werden, die nicht alle Merkmale der im Folgenden beschriebenen Ausführungsformen aufweisen. Ferner werden, um unnötige Wiederholungen zu vermeiden, bestimmte Merkmale nur in Bezug auf einzelne der im Folgenden beschriebenen Ausführungsformen erwähnt. Es wird darauf hingewiesen, dass die einzelnen Ausführungsformen daher nicht nur für sich genommen, sondern auch in einer Zusammenschau betrachtet werden sollen. Anhand dieser Zusammenschau wird der Fachmann erkennen, dass einzelne Ausführungsformen auch durch Einbeziehung von einzelnen oder mehreren Merkmalen anderer Ausführungsformen modifiziert werden können. Es wird darauf hingewiesen, dass eine systematische Kombination der einzelnen Ausführungsformen mit einzelnen oder mehreren Merkmalen, die in Bezug auf andere Ausführungsformen beschrieben werden, wünschenswert und sinnvoll sein kann und daher in Erwägung gezogen und auch als von der Beschreibung umfasst angesehen werden soll.

### Kurze Beschreibung der Zeichnungen

- Figur 1a: zeigt ein schematisches Schaltbild einer Schaltungsvorrichtung gemäß einer bevorzugten Ausführungsform der vorliegenden Erfindung;
- Figur 1b: zeigt ein schematisches Schaltbild einer Schaltungsvorrichtung gemäß einer weiteren bevorzugten Ausführungsform der vorliegenden Erfindung;
- Figur 2: zeigt einen Ausschnitt eines schematisches Schaltbildes einer "Doppel Puls Messeinrichtung" zum Testen der erfindungsgemäßen Schaltungsvorrichtung mit weiteren Details zum Laststromkreis;
- Figur 3: zeigt einen Ausschnitt eines schematischen Schaltbildes einer "Doppel Puls Messeinrichtung" zum Testen der erfindungsgemäßen Schaltungsvorrichtung mit weiteren Details zum Steuerstromkreis;
- Figur 4: zeigt Diagramme zum zeitlichen Verlauf von Kenngrößen eines gewöhnlichen Feldeffekt-Transistors während eines Einschaltvorganges mit einer herkömmlichen Ansteuerung, d.h. ohne eine erfindungsgemäße Rückkopplung;
- Figur 5: zeigt Diagramme zum zeitlichen Verlauf von Kenngrößen eines gewöhnlichen Feldeffekt-Transistors während eines Einschaltvorganges mit der erfindungsgemäßen Schaltvorrichtung, d.h. mit einer erfindungsgemäßen Rückkopplung;
- Figur 6: zeigt eine schematische Skizze für eine beispielhafte Implementierung der erfindungsgemäßen Schaltvorrichtung gemäß einer bevorzugten Ausführungsform auf einer mehrschichtigen Leiterplatte. Dazu ist in der Figur 6a) eine Draufsicht und in der Figur 6b) ein Querschnitt durch die Linie A aus der Figur 6a) gezeigt;
- Figur 7: zeigt das Arbeitsprinzip des in der erfindungsgemäßen Schaltvorrichtung verwendeten Transformators anhand einer schematischen Skizze;
- Figur 8: zeigt experimentelle Messergebnisse für die Ansteuerung eines GaN-HEMTs unter Verwendung der erfindungsgemäßen Schaltungsvorrichtung im Vergleich zur Verwendung einer herkömmlichen Schaltungsvorrichtung bzw. eines Standard Gate-Treibers.

### Detaillierte Beschreibung der Zeichnungen

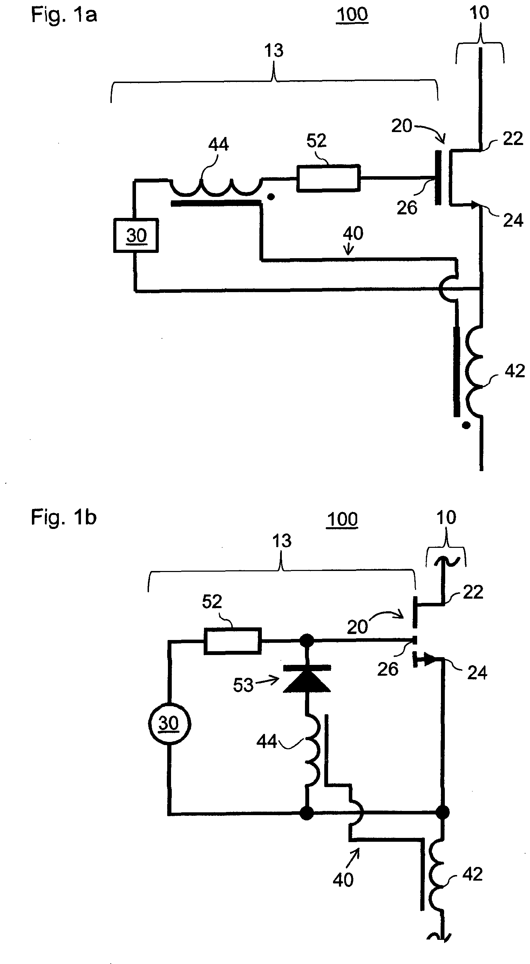

Die **Figur 1a** zeigt ein schematisches Schaltbild einer Schaltungsvorrichtung 100 gemäß einer bevorzugten Ausführungsform der vorliegenden Erfindung. Die Schaltungsvorrichtung 100 umfasst ein ladungsgesteuertes Schaltelement 20, eine Steuereinheit 30 und ein Kopplungselement 40. Bei dem Kopplungselement 40 handelt es sich um einen Transformator mit einer Primärspule 42 und einer Sekundärspule 44. Die Primärspule 42 und die Sekundärspule 44 sind induktiv miteinander gekoppelt. Dies ist in der **Figur 1a** symbolisch mit Hilfe einer Linie zwischen der Primärspule 42 und der Sekundärspule 44 angedeutet. Zudem umfasst die Schaltungsvorrichtung 100 noch einen Widerstand 52, welcher zwischen der Sekundärspule 44 und dem Schaltelement 20 geschaltet ist.

Das ladungsgesteuerte Schaltelement 20 ist beispielsweise ein Halbleiterbauelement bzw. ein Transistor. Das Schaltelement 20 weist einen ersten Laststromanschluss 22 für den Zufluss eines zu schaltenden Laststroms und einen zweiten Laststromanschluss 24 für den Abfluss des zu schaltenden Laststroms auf. Zudem weist das Schaltelement 20 einen Steueranschluss 26 zum Steuern des Schaltelements 20 mittels eines Steuersignals auf. Bei den Laststromanschlüssen 22, 24 handelt es sich insbesondere um die Drain- und Source-Anschlüsse eines Transistors. Bei dem Steueranschluss 26 handelt es sich insbesondere um den Gate-Anschluss eines Transistors.

Die Schaltvorrichtung 100 umfasst bzw. ist unterteilt in einen Laststrompfad bzw. Laststromkreis 10 und einen Steuerstrompfad bzw. Steuerstromkreis 13. Der erste und der zweite Laststromanschluss 22, 24 des Schaltelements 20 sind in dem Laststrompfad 10 integriert, während der Steueranschluss 26 des Schaltelements 20 in dem Steuerstrompfad 13 integriert ist. In dem Laststrompfad 10 fließt ein Laststrom, welcher mit Hilfe des Schaltelements 20 bzw. mit Hilfe des Steuerstrompfads 13 gesteuert werden kann. In dem Laststrompfad 10 kann ein Verbraucher bzw. eine Last integriert sein (in den Figuren 1a und 1b nicht gezeigt), der bzw. die über das Schaltelement 20 ein- und ausgeschaltet werden kann.

Die Steuereinheit 30 ist ausgelegt, um das Steuersignal bereitzustellen, welches an den Steueranschluss 26 des Schaltelements 20 geführt bzw. angelegt wird. Im einfachsten Fall umfasst die Steuereinheit 30 lediglich eine Spannungsquelle zum Bereitstellen einer Steuer- oder Gate-Spannung. Insbesondere umfasst oder ist die Steuereinheit 30 ein Standard Gate-Treiber.

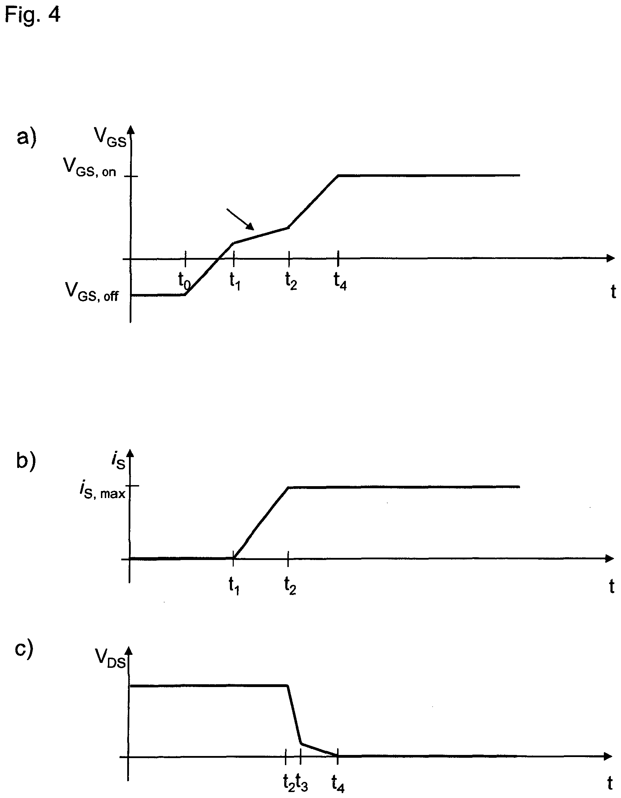

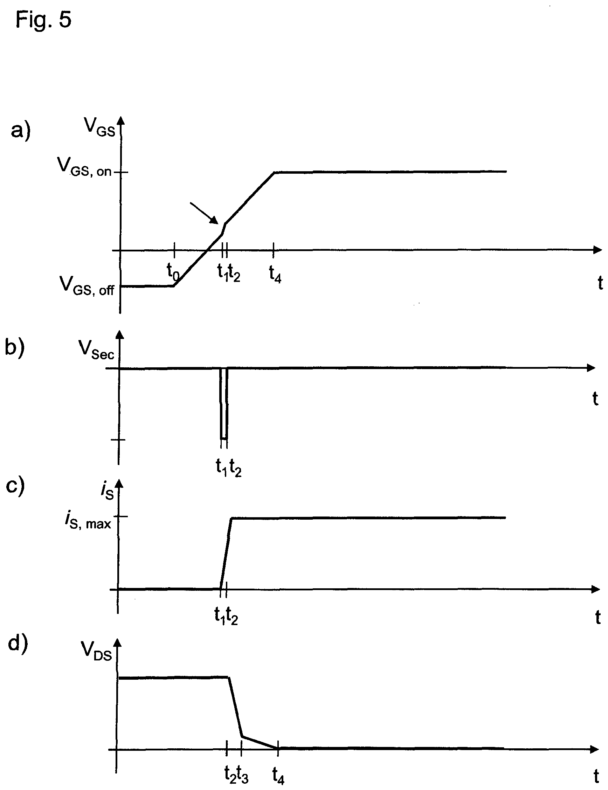

Das Kopplungselement bzw. der Transformator 40 dient zum galvanisch getrennten Übertragen von Energie aus dem Laststrompfad 10 in den Steuerstrompfad 13. Das Koppeln bzw. Übertragen von Energie aus dem Laststrompfad 10 in den Steuerstrompfad 13 erfolgt somit in dem gezeigten Ausführungsbeispiel induktiv mit Hilfe des Transformators 40. Der Transformator 40 sorgt dafür, dass sich infolge einer zeitlichen Änderung des Laststroms im Laststrompfad 10 in der Primärspule 42 ein Magnetfeld aufbaut bzw. ändert, welches auch die Sekundärspule 44 durchdringt bzw. erfasst. In der Sekundärspule 44 wird somit eine Spannung induziert, welche direkt proportional zur zeitlichen Änderung des Laststroms ist. Der Transformator 40 verhält sich während des Einschaltvorgangs zeitweise wie eine zusätzliche Spannungsquelle, wodurch der Steuerstrom bzw. Gate-Strom erhöht wird. Folglich wird auch die Schaltgeschwindigkeit des Schaltelements 20 erhöht. Eine detaillierte Beschreibung des Einschaltvorgangs findet sich im Zusammenhang mit den Figuren 4 und 5.

Der oben beschriebene Effekt ist selbstverstärkend, da sich mit einem erhöhten Gate-Strom auch die zeitliche Änderung des Laststroms erhöht. Ist der maximale Laststrom erreicht und damit der Einschaltvorgang beendet, wird wegen des konstanten Laststroms keine Spannung mehr in der Sekundärspule 44 induziert.

Wie in der **Figur 1a** gezeigt, ist die Sekundärspule 44 zwischen der Steuereinheit 30 und dem Steueranschluss 26 des Schaltelements 20 geschaltet. Zusätzlich ist ein Widerstand 52 zwischen der Sekundärspule 44 und dem Steueranschluss 26 des Schaltelements 20 geschaltet. Dieser Widerstand ist jedoch optional. Die Primärspule 42 ist mit dem zweiten Laststromanschluss 24 des Schaltelements 20 verbunden. Zudem ist die Primärspule 42 mit der Steuereinheit 30 verbunden.

Die **Figur 1b** zeigt ein schematisches Schaltbild einer Schaltungsvorrichtung 100 gemäß einer weiteren bzw. alternative bevorzugten Ausführungsform der vorliegenden Erfindung. Die einzelnen Bauteile und deren Funktion in der Schaltung von Figur 1b entsprechen prinzipiell denen der Schaltung von Figur 1a. Die Schaltung der Figur 1b unterscheidet sich von der Schaltung der Figur 1a im Wesentlichen in der Anordnung der Sekundärspule 44. Wie auch in der Schaltung der Figur 1a ist auch in der Schaltung der Figur 1b die Sekundärspule 44 zwischen der Steuereinheit 30 und dem Steueranschluss 26 des Schaltelements 20 geschaltet. Während die Sekundärspule 44 in der Schaltung von Figur 1a in Reihe mit der Steuereinheit 30 geschaltet ist, ist die Sekundärspule 44 in der Schaltung von Figur 1b jedoch parallel zu der Steuereinheit 30 geschaltet. Auch in der Schaltung von Figur 1b ist der Widerstand 52 zwischen der Steuereinheit 30 und dem Steuerelement 26 des Schaltelements 20 optional. Zusätzlich umfasst die Schaltungsvorrichtung 100 gemäß Figur 1b noch eine Diode 53, welche in Reihe mit der Sekundärspule 44 geschaltet ist. Die Diode 53 ist damit auch parallel zu der Steuereinheit 30 geschaltet. Die Diode 53 verhindert einen hohen Stromfluss der Steuereinheit bzw. des Gate-Treibers 30, wenn an der Steuereinheit bzw. am Gate-Treiber 30 eine positive Spannung anliegt. Insbesondere dann, wenn die Sekundärspule 44 einen sehr geringen Innenwiderstand aufweist, was insbesondere im Gleichstrom- bzw. DC-Betrieb der Fall ist, kann die Diode 53 einen ungewollten Stromfluss durch die Sekundärspule 44 reduzieren oder vermeiden.

Ist eine Spannung, welche an der Sekundärseite, insbesondere an der Sekundärspule 44, anliegt höher als die Spannung der Steuereinheit bzw. des Gate-Treibers 30, so kommt es zu einer zusätzlichen Spannung bzw. einem zusätzlichen Stromfluss am Steuereingang 26 des Schaltelements 20, d.h. das Steuersignal bzw. die Steuerspannung und/oder der Steuerstrom wird erhöht. Dadurch kann der Schaltvorgang vorteilhafterweise beschleunigt wird. Die Spannung an der Sekundärseite bzw. Sekundärspule 44 entsteht durch eine Stromänderung während des Schaltens. Somit kann vorteilhafterweise der Schaltvorgang während des Schaltens selbstenergetisch bzw. selbstverstärkend beschleunigt werden.

Die Ausführungsform gemäß Figur 1b hat gegenüber der Ausführungsform gemäß Figur 1a den Vorteil, dass die normale Ansteuerung des Schaltelements 20 durch die Steuereinheit 30 weniger beeinflusst wird. Insbesondere weist die Ausführungsform der Figur 1b nur wenig parasitäre Elemente auf. Jedoch wird in der Ausführungsform gemäß Figur 1b das Steuersignal nur dann erhöht und damit der Schaltvorgang beschleunigt, wenn die Spannung des Sekundärkreises bzw. der Sekundärspule 44 größer ist als die Spannung der Steuereinheit 30. In der Ausführungsform gemäß Figur 1a dagegen führt jede zusätzliche Spannung der Sekundärspule 44 unmittelbar zu einer Erhöhung des Steuersignals und somit zu einer Beschleunigung des Schaltvorgangs.

Gemäß beiden Ausführungsformen der Figuren 1a und 1b ist die Sekundärspule 44 derart angeordnet und/oder verschaltet, dass bei einem Einschaltvorgang das Steuersignal bzw. der Steuerstrom erhöht wird. Mit anderen Worten ist die Sekundärspule 44 derart angeordnet und/oder verschaltet, dass zusätzlich zum Strom der durch die Steuereinheit 30 fließt bzw. von der Steuereinheit 30 bereitgestellt wird, ein zusätzlicher Strom in den Steueranschluss 26 des Schaltelements 20 fließt. Insbesondere addieren sich der Strom aus der Steuereinheit 30 und der zusätzliche Strom, welcher durch die Sekundärspule 44 bereitgestellt wird. Dies resultiert vorteilhafterweise in einem beschleunigten Schaltvorgang.

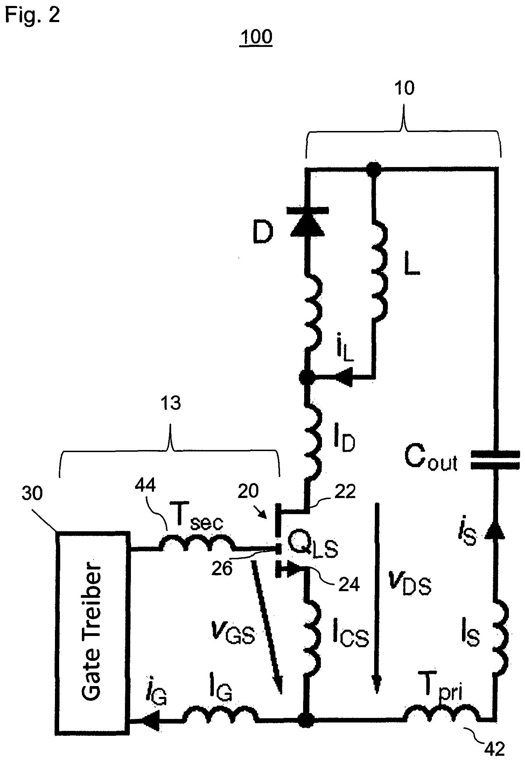

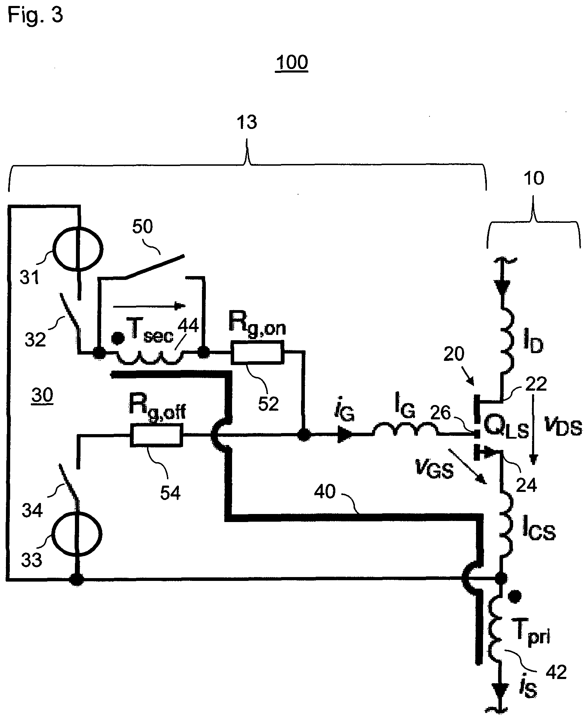

Die **Figuren 2** und **3** zeigen jeweils einen Ausschnitt eines schematischen Schaltbildes einer "Doppel Puls Messeinrichtung" ("Double Pulse Setup") zum Testen der erfindungsgemäßen Schaltungsvorrichtung 100. Zusätzlich zur erfindungsgemäßen Schaltvorrichtung 100 sind in den Figuren 2 und 3 somit auch weitere Bauteile gezeigt, die lediglich zum Testen der Schaltvorrichtung 100 dienen. Während in der Figur 2 zusätzliche Details des Laststromkreises 10 dargestellt sind, sind in der Figur 3 zusätzliche Details des Steuerstromkreises 13 dargestellt. Diese Details umfassen insbesondere weitere optionale Bauteile der jeweiligen Stromkreise bzw. der Schaltvorrichtung 100.

Wie in den Figuren 1a und 1b ist auch in den Figuren 2 und 3 das ladungsgesteuerte Schaltelement 20 bzw. der Transistor Q_{LS} mit dem ersten Laststromanschluss 22 (Drain), dem zweiten Laststromanschluss 24 (Source) und dem Steueranschluss 26 (Gate) zu sehen. Zudem ist auch der Laststromkreis 10 und der Steuerstromkreis 13 erkennbar. Das Schaltelement 20 gehört sowohl dem Laststromkreis 10 als auch dem Steuerstromkreis 13 an. Zudem ist jeweils der Transformator 40 mit der Primärspule Tₚᵣᵢ 42 und der Sekundärspule T_{Sec} 44 gezeigt.

In der **Figur 2** ist die Steuereinheit 30 ein Gate-Treiber. Ferner sind in der Figur 2 parasitäre Induktivitäten, nämlich die parasitäre Drain-Induktivität I_{D}, die Common Source Induktivität I_{CS}, die parasitäre Gate-Induktivität I_{G} und die parasitäre Source-Induktivität I_{S} dargestellt. Die Last des Laststromkreises 10 wird insbesondere durch eine Freilaufdiode D, eine Leistungsspule L und einen Stützkondensator Cₒᵤₜ simuliert. L ist so groß, das der Strom im Schaltmoment im Wesentlichen konstantist. Beispielsweise kann die Induktivität der Leistungsspule L 200 mH betragen, während die Source-, Drain- und Gate-Induktivität jeweils nur etwa 2 nH beträgt.

Der Laststrompfad 10 wird insbesondere durch den Drain-Anschluss 22 des Schaltelements 20, den Source-Anschluss 24 des Schaltelements 20 und die Primärspule 42 gebildet. Ferner sind gemäß der in der Figur 2 gezeigten beispielhaften Schaltung auch noch die Freilaufdiode D, die Leistungsspule L und der Stützkondensator Cₒᵤₜ Bestandteile des Laststrompfades 10.

Der Steuerstrompfad 13 wird gemäß der in der Figur 2 gezeigten beispielhaften Schaltung durch den Gate-Anschluss 26 des Schaltelements 20, dem Gate-Treiber 30 und der Sekundärspule 44 gebildet.

Der Gate-Treiber 30 umfasst einen Standard Gate-Treiber IC ("integrated circuit") mit separate "source" und "sink outputs". Mit Hilfe des Transformators 40 wird Energie zwischen dem Laststrompfad 10 (i_{S}) und dem Steuerstrompfad 13 (i_{G}) übertragen. Die Primärspule 42 (Tₚᵣᵢ) ist zwischen dem Source-Anschluss 24 des Transistors 20 (Q_{LS}) und dem Stützkondensator Cₒᵤₜ angeordnet bzw. geschaltet. Die Sekundärspule 44 (T_{sec}) ist zwischen einem source-Ausgang des Gate-Treibers 30 und dem Einschaltwiderstand 52 (R_{g,on}) angeordnet bzw. geschaltet. Eine positive zeitliche Änderung dis/dt bewirkt eine negative Spannung an der Sekundärspule T_{sec}, welche den Gate-Strom i_{G} erhöht. Die Streu-Induktivität der Primärspule Tₚᵣᵢ summiert sich auf 7 nH und diejenige der Sekundärspule T_{sec} auf 70 nH.

In der **Figur 3** sind weitere Details zur Ansteuerung des Schaltelements 20 dargestellt. Die Steuereinheit 30 umfasst eine erste Spannungsquelle 31, eine zweite Spannungsquelle 33, einen ersten Steuerschalter 32 und einen zweiten Steuerschalter 34. Mit Hilfe der Schalter 32 und 34 kann das Schaltelement 20 angesteuert, d.h. ein- und ausgeschaltet werden. Beim Einschaltvorgang ist der erste Schalter 32 geschlossen und der zweite Schalter 34 geöffnet. Beim Ausschaltvorgang ist der erste Schalter 32 geöffnet und der zweite Schalter 34 geschlossen. Das Ein- und Ausschalten des Schaltelements 20 erfolgt somit über zwei separate Pfade des Steuerstromkreises 13.

Der Einschaltvorgang erfolgt über einen Einschaltepfad, welcher die erste Spannungsquelle 31, den ersten Steuerschalter 32 und die Sekundärspule 44 umfasst. Ferner kann der Einschaltepfad den Einschaltwiderstand 52 und einen Überbrückungsschalter 50 umfassen. Der Überbrückungsschalter 50 ist parallel zur Sekundärspule 44 geschaltet und dient zum Überbrücken bzw. Kurzschließen der Sekundärspule 44. Mit dem Überbrückungsschalter 50 kann somit die induktive Rückkopplung vom Laststrompfad 10 in den Steuerstrompfad 13 aktiviert und deaktiviert werden. Der Überbrückungsschalter 50 wird vorzugsweise während des Ausschaltvorgangs geschlossen, so dass während des Ausschaltvorgangs keine induktive Rückkopplung aus dem Laststrompfad 10 in den Steuerstrompfad 13 erfolgt. Der Überbrückungsschalter 50 wird somit vorzugsweise simultan zu den Steuerschaltern 32 und 34 geschalten und hat vorzugsweise den gleichen Schaltzustand wie der zweite Steuerschalter 34. Auf diese Weise kann ein Schwingen der Schaltvorrichtung 100 beim Ausschalten vermieden werden.

Der Ausschaltvorgang erfolgt über einen Ausschaltepfad, welcher die zweite Spannungsquelle 33, den zweiten Steuerschalter 34 und einen externen Ausschaltwiderstand 54 (R_{G,off}) umfasst. Beim Ausschalten erfolgt keine induktive Rückkopplung.

Gemäß der in der Figur 3 beispielhaft gezeigten Schaltung umfasst der Steuerstrompfad 13 den oben beschriebenen Einschaltepfad, den oben beschriebenen Ausschaltepfad sowie den Steueranschluss 26 des Schaltelements 20. Der Laststrompfad 10 umfasst den Drain-Anschluss 22 des Schaltelements 20, den Source-Anschluss 24 des Schaltelements 20 und die Primärspule 42 des Transformators 40.

Die **Figur 4** zeigt beispielhaft anhand von Diagrammen den zeitlichen Verlauf von Kenngrößen eines gewöhnlichen Feldeffekt-Transistors 20 während eines Einschaltvorganges am Feldeffekt-Transistor 20. Dabei ist der Feldeffekt-Transistor 20 als Schaltelement gemäß der Figur 3 geschaltet, allerdings ohne einen Transformator 40 als Kopplungselement zwischen dem Laststrompfad 10 und dem Steuerstrompfad 13. Die Ordinate (Y-Achse) der Diagramme zeigt in der Figur 4a die Gate-Source Spannung V_{GS}, in der Figur 4b den Laststrom is und in der Figur 4c die Drain-Source Spannung Vos des Feldeffekt-Transistors 20. In Richtung der Abszisse (X-Achse) der Diagramme 4a, 4b und 4c ist der zeitlichen Verlauf t von V_{GS}, is und V_{DS} dargestellt.

Im Zeitintervall 0 ≤ t < t₀ stellt die Steuereinheit 30 ein Steuersignal für den ausgeschaltenen Zustand des Feldeffekt-Transistors 20 mit einer Spannung kleiner oder gleich 0V bereit und die Spannung V_{GS,off} liegt zwischen Gate und Source des Feldeffekt-Transistors 20 an (Figur 4a). V_{GS,off} ist so gewählt, dass der Feldeffekt-Transistor 20 in Drain-Source Richtung gesperrt ist, das bedeutet dass kein Laststrom i_{S} im Laststrompfad fließt (Figur 4b). V_{GS,off} kann beispielsweise den Wert 0V haben. V_{GS,off} kann auch, wie in Figur 4a gezeigt, einen negativen Wert annehmen, um die Sperrung in Drain-Source Richtung des Feldeffekt-Transistors 20 zusätzlich zu verstärken bzw. sicher zu stellen. Während der Feldeffekt-Transistor 20 in Drain-Source Richtung gesperrt ist, liegt zwischen Drain und Source eine Spannung V_{DS} größer als 0V an (Figur 4c).

Zum Zeitpunkt t=t₀ wird an der Steuereinheit 30 ein Steuersignal für den eingeschaltenen Zustand des Feldeffekt-Transistors 20 mit einer Spannung größer 0V bereitgestellt. Durch den Einschaltwiderstand 52 und der Zuleitung zwischen der Steuereinheit 30 und dem Gate des Feldeffekt-Transistors 20 liegt die maximale Spannung V_{GS,on} nicht sofort an (Figur 4a). Dabei ist die Spannung V_{GS,on} so gewählt, dass der Feldeffekt-Transistor 20 in Drain-Source Richtung sicher vollständig leitet.

Im Zeitintervall to < t < t₁ steigt die Spannung V_{GS} zwischen Gate und Source des Feldeffekt-Transistors 20 an, allerdings limitiert in seiner Steigung (*dV_{Gs}*/*dt*) durch den Einschaltwiderstand 52 und die Zuleitung. Die Spannung V_{GS} ist dabei noch so niedrig, dass der Feldeffekt-Transistor 20 in Drain-Source Richtung weiterhin gesperrt bleibt und kein Laststrom *i*ₛ im Laststrompfad fließt (Figur 4b). Somit bleibt auch V_{DS} größer als 0V (Figur 4c).

Zum Zeitpunkt t=t₁ erreicht die Spannung V_{GS} (Figur 4a) einen Wert, bei dem der Feldeffekt-Transistor 20 in Drain-Source Richtung öffnet. Es fließt aber noch kein Laststrom *i*ₛ im Laststrompfad (Figur 4b).

Im Zeitintervall t₁ < t < t₂ steigt die Spannung V_{GS} zwischen Gate und Source des Feldeffekt-Transistors 20 weiter an, der Kanal in Drain-Source Richtung wird weiter geöffnet und der Laststrom *i*ₛ im Laststrompfad 10 beginnt mit einer Steigung *diₛ*/*dt* zu fließen (Figur 4b). Durch den Anstieg des Laststroms *i*ₛ bildet sich aber auch eine Spannung an der parasitären Common-Source Induktivität Ics, die der Spannung V_{GS} im Steuerstrompfad 13 entgegenwirkt und somit deren Steigung *dV_{G}s*/*dt* reduziert. Dieser Zeitabschnitt ist durch den Pfeil in Figur 4a hervorgehoben.

Zum Zeitpunkt t=t₂ erreicht der Laststrom *i*ₛ im Laststrompfad 10 sein Maximum, welches durch den jeweiligen Feldeffekt-Transistor 20 vorgegeben ist (Figur 4b). Die Steigung *di*_{S}/*dt* fällt somit auf einen Wert von 0 und die Spannung an der parasitären Common-Source Induktivität I_{CS} wird nicht weiter erhöht.

Im Zeitintervall t>t₂ und t<t₄ steigt die Spannung V_{GS} zwischen Gate und Source des Feldeffekt-Transistors 20, limitiert durch den Einschaltwiderstand 52 und die Zuleitung, mit der Steigung (*dV_{GS}*/*dt*) an und erreicht bei t=t₄ ihr Maximum mit V_{GS,on}. Dabei verringert sich die Drain-Source Spannung Vos von ihrem maximalen Wert bei t=t₂ zunächst zügig durch das Entladen einer parasitären Kapazität des Feldeffekt-Transistors 20 in Drain-Source Richtung bis zum Zeitpunkt t=t₃. Nach der vollständigen Entladung der parasitären Kapazität des Feldeffekt-Transistors 20 wird durch die weiterhin steigende Spannung V_{GS} zwischen Gate und Source der Kanalwiderstand in Drain-Source Richtung verringert und die Drain-Source Spannung Vos fällt bis zum Zeitpunkt t=t₄ auf den Wert 0V (Figur 4c).

Ab dem Zeitpunkt t=t₄ liegt an dem Feldeffekt-Transistor 20 die maximale Gate-Source Spannung V_{GS,on} an, es fließt der maximale Laststrom *i*ₛ im Laststrompfad und die Spannung V_{DS} bleibt auf dem Wert 0V. Somit ist der Feldeffekt-Transistor 20 zum Zeitpunkt t=t₄ vollständig eingeschalten. Die Zeitdauer des Einschaltvorganges bemisst sich demnach nach dem Zeitpunkt des Einschaltens der Steuereinheit 30 bei t=t₀ bis zum Zeitpunkt t=t₄.

Die **Figur 5** zeigt beispielhaft anhand von Diagrammen den zeitlichen Verlauf von Kenngrößen eines Feldeffekt-Transistors 20 und einer Sekundärspule 44 eines Transformators 40 während eines Einschaltvorganges am Feldeffekt-Transistor 20, wobei der Feldeffekt-Transistor 20 erfindungsgemäß, wie in der Figur 3 gezeigt, geschaltet ist, also mit einen Transformator 40 als Kopplungselement zwischen dem Laststrompfad 10 und dem Steuerstrompfad 13. Die Diagramme der Figur 5 sind so ausgelegt, dass sie mit den Diagrammen der Figur 4 vergleichbar sind. Die Ordinate (Y-Achse) der Diagramme zeigt in Figur 5a die Gate-Source Spannung V_{GS}, in der Figur 5b die Spannung V_{Sec} über der Sekundärspule 44 des Transformators 40, in der Figur 5c den Laststrom *i*_{S} und in der Figur 5d die Drain-Source Spannung V_{DS} des Feldeffekt-Transistors 20. In Richtung der Abszisse (X-Achse) der Diagramme 5a, 5b, 5c und 5d ist der zeitlichen Verlauf t von V_{GS}, V_{sec}, *i*_{S} und V_{DS} dargestellt.

Im Zeitintervall 0 ≤ t < t₁ ist das Einschaltverhalten in der erfindungsgemäßen Schaltvorrichtung das Gleiche wie das in Figur 4 beschriebene Einschaltverhalten. Das bedeutet, dass der zeitlichen Verlauf t von V_{GS}, is und V_{DS} identisch ist. Dies ist darin begründet, dass in diesem Zeitintervall kein Laststrom *i*_{S} im Laststrompfad fließt (Figur 5c), dadurch auch die Steigung *di*_{S}/*dt* den Wert 0 behält und somit auch keine Spannung an der Primärspule 42 des Transformators 40 induziert wird. Somit liegt eine Spannung V_{sec} mit dem Wert 0V an der Sekundärspule 44 des Transformators an (Figur 5b).

Zum Zeitpunkt t=t₁ erreicht die Spannung V_{GS} (Figur 5a) einen Wert, bei dem der Feldeffekt-Transistor 20 in Drain-Source Richtung öffnet. Es fließt aber noch kein Laststrom *i*_{S} im Laststrompfad (Figur 5c) und es liegt eine Spannung V_{sec} mit dem Wert 0V an der Sekundärspule 44 des Transformators (Figur 5b) an.

Im Zeitintervall t₁ < t < t₂ steigt die Spannung V_{GS} zwischen Gate und Source des Feldeffekt-Transistors 20 weiter an, der Kanal in Drain-Source Richtung wird weiter geöffnet und der Laststrom i_{S} im Laststrompfad 10 beginnt mit einer Steigung *di_{S}*/*dt* zu fließen (Figur 5c). Durch den Anstieg des Laststroms *iₛ* bildet sich, wie bereits in Figur 4 beschrieben, eine Spannung an der parasitären Common-Source Induktivität I_{CS}, die der Spannung V_{GS} im Steuerstrompfad 13 entgegenwirkt und somit deren Steigung *dV_{GS}*/*dt* reduziert. Zusätzlich wird durch den Anstieg des Laststroms *iₛ* aber auch ein Magnetfeld an bzw. in der Primärspule 42 des Transformators 40 aufgebaut. Dadurch wird wiederum eine negative Spannung V_{sec} an der Sekundärspule 44 des Transformators induziert (Figur 5b). Die negative Spannung V_{sec} wirkt wie eine zusätzliche Spannungsquelle zu der bereits anliegenden Spannung V_{GS}, die von der Steuereinheit 30 bereitgestellt wird. Dadurch erhöht sich auch die Steigung *dV_{GS}*/*dt* und die Gate-Source Spannung V_{GS} steigt schneller an. Durch die schneller ansteigende Gate-Source Spannung V_{GS} erhöht sich auch die Steigung *di_{S}ldt* und somit erfolgt wiederum ein schnellerer Anstieg des Laststroms. Dieser Effekt verstärkt sich selbst, solange der maximale Laststrom *iₛ* noch nicht erreicht ist. Somit wirkt die Spannung V_{sec} der Spannung an der parasitären Common-Source Induktivität Ics entgegen. Durch geeignete Wahl des Übertragungsfaktors k (Wicklungsverhältnis der Primärspule zur Sekundärspule) überwiegt der Einfluss der zusätzlichen Spannung V_{sec} zur Erhöhung der Steigung *dV_{GS}*/*dt* den entgegen wirkenden Einfluss der Spannung an der parasitären Common-Source Induktivität I_{CS}. Der beschriebene Zeitabschnitt ist durch den Pfeil in der Figur 5a hervorgehoben.

Zum Zeitpunkt t=t₂ erreicht der Laststrom *i*_{S} im Laststrompfad 10 sein Maximum, welches durch den jeweiligen Feldeffekt-Transistor 20 vorgegeben ist (Figur 5c). Die Steigung *dis*/*dt* fällt auf einen Wert von 0. Die Spannung an der parasitären Common-Source Induktivität I_{CS} wird somit nicht weiter erhöht und es wird kein Magnetfeld mehr an bzw. in der Primärspule 42 des Transformators 40 aufgebaut. Dadurch liegt wieder eine Spannung V_{sec} mit dem Wert 0V an der Sekundärspule 44 des Transformators an (Figur 5b).

Durch den Einsatz des Transformators 40 zur selbstverstärkenden Ansteuerung des Feldeffekt-Transistors 20 verkürzt sich die Zeitdauer vom Zeitpunkt t=t₁ bis zum Zeitpunkt t=t₂ (Figur 5) gegenüber der entsprechenden Zeitdauer einer gewöhnlichen Ansteuerung des Feldeffekt-Transistors 20 (Figur 4).

Im Zeitintervall t₂ < t < t₄ ist das Einschaltverhalten in der erfindungsgemäßen Schaltvorrichtung wiederum das Gleiche wie das in Figur 4 beschriebene Einschaltverhalten. Dabei steigt die Spannung V_{GS} zwischen Gate und Source des Feldeffekt-Transistors 20, limitiert durch den Einschaltwiderstand 52 und die Zuleitung, mit der Steigung *dV_{GS}*/*dt* an und erreicht bei t=t₄ ihr Maximum mit V_{GS,on}. Dabei verringert sich die Drain-Source Spannung Vos von ihrem maximalen Wert bei t=t₂ zunächst zügig durch das Entladen einer parasitären Kapazität des Feldeffekt-Transistors 20 in Drain-Source Richtung bis zum Zeitpunkt t=t₃. Nach der vollständigen Entladung der parasitären Kapazität des Feldeffekt-Transistors 20 wird durch die weiterhin steigende Spannung V_{GS} zwischen Gate und Source der Kanalwiderstand in Drain-Source Richtung verringert und die Drain-Source Spannung V_{DS} fällt bis zum Zeitpunkt t=t₄ auf den Wert 0V (Figur 5d).

Ab dem Zeitpunkt t=t₄ liegt an dem Feldeffekt-Transistor 20 die maximale Gate-Source Spannung V_{GS,on} an, es fließt der maximale Laststrom *i*_{S} im Laststrompfad und die Spannung Vos bleibt auf dem Wert 0V. Somit ist der Feldeffekt-Transistor 20 zum Zeitpunkt t=t₃ vollständig eingeschalten.

Die Zeitdauer des Einschaltvorganges bemisst sich wiederum nach dem Zeitpunkt des Einschaltens der Steuereinheit 30 bei t=t₀ bis zum Zeitpunkt t=t₄. Die Zeitdauer vom Zeitpunkt t=t₀ bis zum Zeitpunkt t=t₁ und die Zeitdauer vom Zeitpunkt t=t₂ bis zum Zeitpunkt t=t₄ ist bei der gewöhnlichen, wie auch bei der erfindungsgemäßen Ansteuerung des Feldeffekt-Transistors 20 gleich (Figuren 4 und 5). Durch die verkürzte Zeitdauer vom Zeitpunkt t=t₁ bis zum Zeitpunkt t=t₂ bei der erfindungsgemäßen Ansteuerung gegenüber der gewöhnlichen Ansteuerung des Feldeffekt-Transistors 20 (Figuren 4 und 5) ergibt sich aber vorteilhafterweise insgesamt eine verkürzte Zeitdauer vom Zeitpunkt t=t₀ bis zum Zeitpunkt t=t₄ für die erfindungsgemäße Ansteuerung des Feldeffekt-Transistors 20.

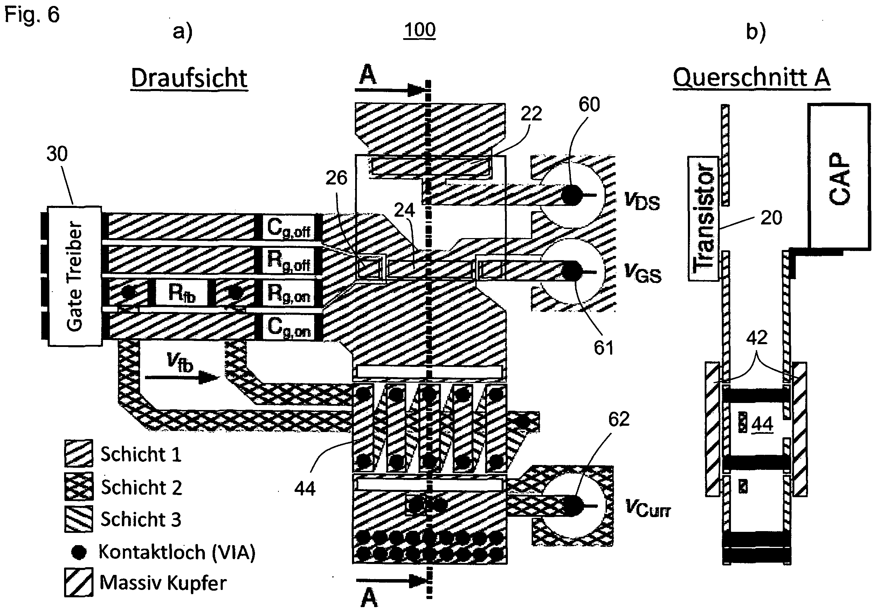

Die **Figur 6** zeigt eine schematische Skizze für eine beispielhafte Implementierung der erfindungsgemäßen Schaltvorrichtung 100 gemäß einer bevorzugten Ausführungsform auf einer mehrschichtigen Leiterplatte. Dazu ist in der Figur 6a) eine Draufsicht und in der Figur 6b) ein Querschnitt durch die Linie A aus der Figur 6a) dargestellt. Die Implementierung kann mittels Standard Leiterplattentechnologien erfolgen.

Die Leiterplatte weist drei unterschiedliche Schichten bzw. Ebenen (Layer 1 bis Layer 3) auf. Für die Implementierung kann das bekannte "Strip line" Konzept verwendet werden, um parasitäre Induktivitäten zwischen dem Source-Anschluss 24 des Schaltelements 20 (Q_{LS}) zu reduzieren. Das "Strip line" Konzept ist insbesondere durch eine Leitungsführung derart charakterisiert, dass der Strom auf einer Schicht der Leiterplatte hin und auf einer anderen Schicht der Leiterplatte zurück fließt. Durch das Verwenden des "Strip line" Konzeptes können parasitäre Effekte reduziert und somit die Schaltgeschwindigkeit des Schaltelements 20 weiter erhöht werden.

Die Primärspule 42 ist aus nur einer Windung aus Kupfer gebildet. Diese ist in der Draufsicht der Figur 6a) aus Gründen der Übersichtlichkeit nicht gezeigt. Die Sekundärspule 44 ist in den Layern 1 und 3, welche über Durchgangslöcher (VIAs) verbunden sind, implementiert.

In der Figur 6a) sind zudem Messpunkte 60, 61, 62 dargestellt, mit denen jeweils V_{DS}, V_{GS} und V_{curr} gemessen werden können. Mit dem Messpunkt 62 (V_{curr}) kann die zeitliche Änderung di_{S}/dt des Laststroms i_{S} gemessen werden. Der in der Figur 6a) gezeigte Widerstand R_{fb} kann ein einstellbarer Widerstand sein. Insbesondere kann anstelle dieses einstellbaren Widerstands R_{fb} ein Überbrückungsschalter vorgesehen werden. Der in der Figur 6b) mit "CAP" bezeichnete Kondensator entspricht dem Kondensator Cₒᵤₜ der Figur 2.

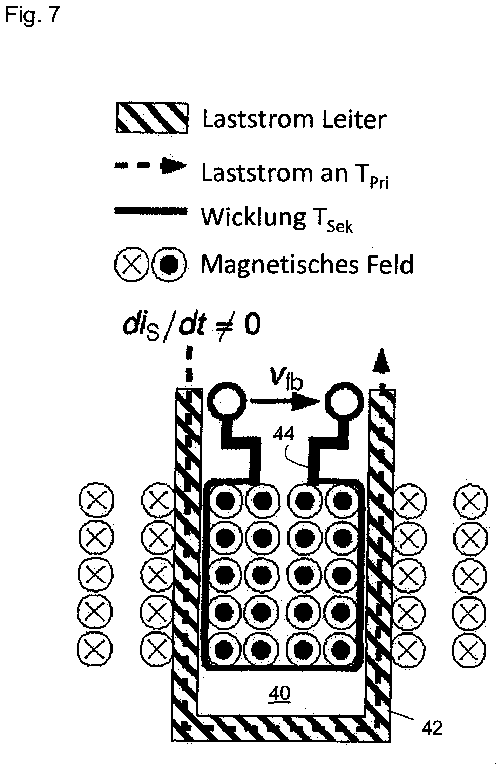

In der **Figur 7** ist das Arbeitsprinzip des Transformators 40 schematisch dargestellt. Dabei ist die Primärspule 42 aus nur einer Windung gebildet. Durch die Primärspule 42 fließt der Laststrom i_{S}. Die Sekundärspule bzw. die Sekundärseite 44 des Transformators 40 wird von der Primärspule bzw. der Primärseite 42 des Transformators 40 eingeschlossen. Auf Grund einer zeitlichen Änderung dis/dt des Laststroms i_{S} wird durch die Primärseite 42 des Transformators ein Magnetfeld bzw. ein magnetischer Fluss erzeugt. Die magnetische Flussänderung induziert wiederum eine Spannung V_{fb} in der Sekundärseite 44 des Transformators 40.

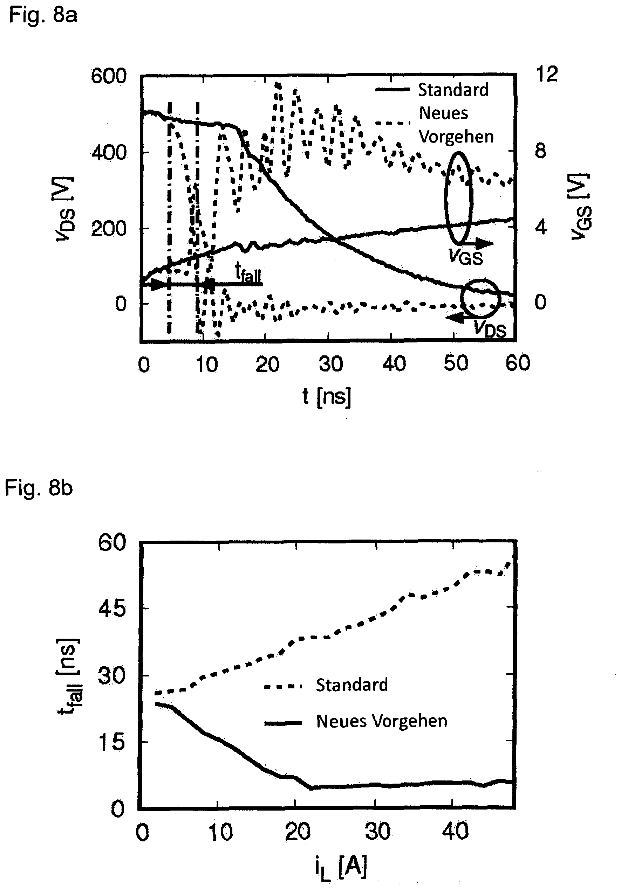

Die **Figur 8** zeigt experimentelle Messergebnisse für die Ansteuerung eines 650 V GaN-HEMTs unter Verwendung der erfindungsgemäßen Schaltungsvorrichtung 100 (in den Diagrammen der Figur 8 mit "new approach" bzw. "n. App." gekennzeichnet) im Vergleich zur Verwendung einer herkömmlichen Schaltungsvorrichtung bzw. eines Standard Gate-Treibers (in den Diagrammen der Figur 8 mit "standard" bzw. "std." gekennzeichnet).

Wie in der Figur 8a zu erkennen ist, zeigt ein Standard Gate-Treiber bei einer Drain-Source Spannung von V_{DS} = 500V, einem Laststrom von i_{L} = 48A, einem Einschaltwiderstand von R_{G,on} = 4,7 Ohm und einem Widerstand R_{fb} = 0 Ohm ein dV/dt von bis zu 55 V/ns. Die sogenannte Fallzeit (t_{fall}), welche die Zeit repräsentiert, in der V_{DS} von 95% auf 5% gefallen ist, beträgt t_{fall} = 58,8 ns. Mit der erfindungsgemäßen Schaltungsvorrichtung dagegen ("new approach") konnte bei ansonsten gleichbleibenden Parametern dV/dt auf 260 V/ns erhöht und t_{fall} auf 5,6 ns verringert werden.

In der Figur 8b ist die Fallzeit t_{fall} als Funktion des Laststroms i_{L} aufgetragen. Der Standard Gate-Treiber zeigt einen Anstieg von t_{fall} mit steigendem Laststrom i_{L}. Im Gegensatz dazu nimmt bei der erfindungsgemäßen Schaltvorrichtung ("new approach") t_{fall} mit steigendem i_{L} ab. Bei i_{L} = 18 A bleibt schließlich t_{fall} in etwa konstant. Dieser Abfall von t_{fall} kann durch den selbstverstärkenden Effekt, welcher bei der erfindungsgemäßen Schaltungsvorrichtung auftritt, erklärt werden.

### Bezugszeichenliste

- 10: Laststrompfad / Laststromkreis
- 13: Steuerstrompfad / Steuerstromkreis
- 20: ladungsgesteuertes Schaltelement / Transistor
- 22: erster Laststromanschluss / Drain oder Source
- 24: zweiter Laststromanschluss / Source oder Drain
- 26: Steueranschluss / Gate
- 30: Steuereinheit
- 31: erste Steuer-Spannungsquelle / Spannungsquelle des Einschaltepfads
- 32: erster Steuerschalter / Schalter des Einschaltepfads
- 33: zweite Steuer-Spannungsquelle / Spannungsquelle des Ausschaltepfads
- 34: zweiter Steuerschalter / Schalter des Ausschaltepfads
- 40: Kopplungselement / Transformator
- 42: Primärspule / Primärseite des Transformators
- 44: Sekundärspule / Sekundärseite des Transformators
- 50: Überbrückungsschalter
- 52: Widerstand / externer Einschaltwiderstand
- 53: Diode
- 54: Widerstand / externer Ausschaltwiderstand
- 60: Messpunkt
- 61: Messpunkt
- 62: Messpunkt
- 100: Schaltungsvorrichtung
- D: Freilaufdiode
- L: Leistungsspule
- i_{L}: Strom durch die Leistungsspule L
- iₛ: Strom im Laststromkreis / Laststrom / Source-Strom
- I_{D}: parasitäre Drain-Induktivität
- Q_{LS}: Leistungstransistor, z.B. GaN HEMT
- T_{sec}: Sekundärspule
- I_{CS}: Common Source-Induktivität
- I_{G}: parasitäre Gate-Induktivität
- Tₚᵣᵢ: Primärspule
- I_{S}: parasitäre Source-Induktivität
- Cₒᵤₜ: Stützkapazität
- R_{g,on}: Gatevorwiderstand für den Einschaltvorgang
- R_{g,off}: Gatevorwiderstand für den Ausschaltvorgang
- R_{fb}: Widerstand / einstellbarer Widerstand
- i_{G}: Gate-Strom
- V_{GS}: Gate-Source Spannung
- V_{DS}: Drain-Source Spannung
- V_{fb}: induzierte Spannung in der Sekundärspule

## Patentansprüche

1. Schaltungsvorrichtung (100) umfassend:
- ein ladungsgesteuertes Schaltelement (20) mit einem ersten Laststromanschluss (22) für den Zufluss eines zu schaltenden Laststroms, einen zweiten Laststromanschluss (24) für den Abfluss des zu schaltenden Laststroms und einen Steueranschluss (26) zum Steuern des Schaltelements (20) mittels eines Steuersignals, wobei der erste und der zweite Laststromanschluss (22, 24) in einem Laststrompfad (10) der Schaltungsvorrichtung (100) integriert sind und wobei der Steueranschluss (26) in einem Steuerstrompfad (13) der Schaltungsvorrichtung (100) integriert ist;
- eine Steuereinheit (30) zum Bereitstellen des Steuersignals;
- ein Kopplungselement (40) zum galvanisch getrennten Übertragen von Energie aus dem Laststrompfad (10) in den Steuerstrompfad (13), wobei das Kopplungselement (40) ein Transformator mit einer Primärspule (42) und einer Sekundärspule (44) ist, wobei der Transformator derart ausgelegt und angeordnet ist, dass er bei einem Einschaltvorgang des Schaltelements (20) eine zusätzliche Spannung am Steueranschluss (26) des Schaltelements (20) bereitstellt, um somit das Steuersignal zu erhöhen, **dadurch gekennzeichnet, dass** der Transformator weiter derart ausgelegt und angeordnet ist, die Sekundärspule (44) des Transformators während eines Ausschaltvorgangs des Schaltelements (20) zu deaktivieren.

2. Schaltungsvorrichtung (100) nach Anspruch 1,
wobei die Sekundärspule (44) zwischen der Steuereinheit (30) und dem Steueranschluss (26) des Schaltelements (20) geschaltet ist, und/oder
wobei die Sekundärspule (44) in Reihe mit der Steuereinheit (30) oder parallel zu der Steuereinheit (30) geschaltet ist.

3. Schaltungsvorrichtung (100) nach einem der Ansprüche 1 bis 2,
wobei die Primärspule (42) des Transformators mit dem ersten oder zweiten Laststromanschluss (22, 24) des Schaltelements (20) verbunden ist, und
wobei die Sekundärspule (44) des Transformators mit dem Steueranschluss (26) des Schaltelements (20) verbunden ist.

4. Schaltungsvorrichtung (100) nach einen der vorangegangenen Ansprüche, wobei die Steuereinheit (30) zumindest eine Spannungsquelle (31, 32) und/oder einen Standard Gate-Treiber umfasst.

5. Schaltungsvorrichtung (100) nach einem der vorangegangenen Ansprüche, wobei die Steuereinheit (30) galvanisch mit dem Steueranschluss (26) des Schaltelements (20) verbunden ist.

6. Schaltungsvorrichtung (100) nach einem der Ansprüche 1 bis 3, ferner umfassend:
- einen einstellbaren Deaktivierungswiderstand oder einen Deaktivierungsschalter (50) zum Deaktivieren der Sekundärspule; und/oder
- einen externen Einschaltwiderstand (52), der zwischen der Sekundärspule (44) des Transformators und dem Steueranschluss (26) des Schaltelements (20) geschaltet ist.

7. Schaltungsvorrichtung (100) nach einem der Ansprüche 1 bis 6, wobei der Steuerstrompfad (13) einen Einschaltepfad, über den ein Einschalten des Schaltelements (20) erfolgt, und einen Ausschaltepfad, über den ein Ausschalten des Schaltelements (20) erfolgt, umfasst, wobei vorzugsweise der Einschaltepfad die Sekundärspule (44) des Transformators umfasst.

8. Schaltungsvorrichtung (100) nach einem der vorangegangenen Ansprüche, wobei das Kopplungselement (40) ein integraler Bestandteil einer Leiterplatte ist.

9. Verfahren zur selbstverstärkenden Ansteuerung eines ladungsgesteuerten Schaltelements (20), umfassend:
- Bereitstellen des ladungsgesteuerten Schaltelements (20) mit einem ersten Laststromanschluss (22) für den Zufluss eines zu schaltenden Laststroms, einem zweiten Laststromanschluss (24) für den Abfluss des zu schaltenden Laststroms und einem Steueranschluss (26) zum Steuern des Schaltelements (20), wobei der erste und der zweite Laststromanschluss (22, 24) in einen Laststrompfad (10) und der Steueranschluss (26) in einen Steuerstrompfad (13) integriert wird;
- Steuern des ladungsgesteuerten Schaltelements (20) mit Hilfe einer Steuereinheit (30); und
- galvanisch getrenntes Übertragen von Energie aus dem Laststrompfad (10) in den Steuerstrompfad (13) während eines Einschaltvorgangs des Schaltelements (20) mit Hilfe eines Kopplungselements (40), wobei das Kopplungselement (40) ein Transformator mit einer Primärspule (42) und einer Sekundärspule (44) ist, **dadurch gekennzeichnet, dass**
- Deaktivieren der Sekundärspule (44) des Transformators während eines Ausschaltvorgangs des Schaltelements (20).

10. Verwendung eines Transformators zur selbstverstärkenden Ansteuerung eines ladungsgesteuerten Schaltelements (20), wobei der Transformator Bestandteil einer Schaltungsvorrichtung (100) ist und derart ausgelegt und angeordnet wird, dass während eines Einschaltvorgangs des Schaltelements (20) Energie aus einem Laststrompfad (10) der Schaltungsvorrichtung (100) in einen Steuerstrompfad (13) der Schaltungsvorrichtung übertragen wird, wobei eine Primärspule (42) des Transformators mit einem Laststromanschluss (22, 24) des Schaltelements (20) verbunden wird und wobei eine Sekundärspule (44) des Transformators mit einem Steueranschluss (26) des Schaltelements (20) verbunden wird, **dadurch gekennzeichnet, dass** der Transformator weiter derart ausgelegt und angeordnet ist, die Sekundärspule (44) des Transformators während eines Ausschaltvorgangs des Schaltelements (20) zu deaktivieren.

## Claims

1. Switching device (100) comprising:
a charge-controlled switching element (20) comprising a first load current terminal (22) for the inflow of a load current to be switched, a second load current terminal (24) for the outflow of the load current to be switched, and a control terminal (26) for controlling the switching element (20) by means of a control signal, wherein the first and the second load current terminal (22, 24) are integrated in a load current path (10) of the switching device (100), and wherein the control terminal (26) is integrated in a control current path (13) of the switching device (100);
a control unit (30) for providing the control signal;
a coupling element (40) for galvanically isolated transfer of energy from the load current path (10) into the control current path (13), wherein the coupling element (40) is a transformer comprising a primary coil (42) and a secondary coil (44), wherein
the transformer is designed and arranged to provide an additional voltage at the control terminal (26) of the switching element (20) during a switch-on operation of the switching element (20) in order to increase the control signal,
**characterized in that**
the transformer is further designed and arranged to deactivate the secondary coil (44) of the transformer during a switch-off operation of the switching element (20).

2. Switching device (100) according to claim 1,
wherein the secondary coil (44) is connected between the control unit (30) and the control terminal (26) of the switching element (20), and/or
wherein the secondary coil (44) is connected in series with the control unit (30) or in parallel with the control unit (30).

3. Switching device (100) according to any one of claims 1 to 2,
wherein the primary coil (42) of the transformer is connected to the first or the second load current terminal (22, 24) of the switching element (20), and
wherein the secondary coil (44) of the transformer is connected to the control terminal (26) of the switching element (20).

4. Switching device (100) according to any one of the preceding claims, wherein the control unit (30) comprises at least one voltage source (31, 32) and/or a standard gate driver.

5. Switching device (100) according to any one of the preceding claims, wherein the control unit (30) is galvanically connected to the control terminal (26) of the switching element (20).

6. Switching device (100) according to any one of claims 1 to 3, further comprising:
an adjustable deactivation resistor or a deactivation switch (50) for deactivating the secondary coil; and/or
an external switch-on resistor (52) connected between the secondary coil (44) of the transformer and the control terminal (26) of the switching element (20).

7. Switching device (100) according to any one of claims 1 to 6, wherein the control current path (13) comprises a switch-on path via which a switch-on operation of the switching element (20) is implemented, and a switch-off path via which a switch-off operation of the switching element (20) is implemented, wherein the switch-on path preferably comprises the secondary coil (44) of the transformer.

8. Switching device (100) according to any one of the preceding claims, wherein the coupling element (40) is an integral part of a printed circuit board.

9. Method for self-amplifying driving a charge-controlled switching element (20), comprising the steps of:
providing the charge-controlled switching element (20) comprising a first load current terminal (22) for the inflow of a load current to be switched, a second load current terminal (24) for the outflow of the load current to be switched, and a control terminal (26) for controlling the switching element (20), wherein the first and the second load current terminal (22, 24) are integrated in a load current path (10) and the control terminal (26) is integrated in a control current path (13);
controlling the charge-controlled switching element (20) by means of a control unit (30); and
transferring energy from the load current path (10) into the control current path (13) in an electrically isolated manner during a switch-on operation of the switching element (20) by means of a coupling element (40), wherein the coupling element (40) is a transformer comprising a primary coil (42) and a secondary coil (44);
**characterized by**
deactivating the secondary coil (44) of the transformer during a switch-off operation of the switching element (20).

10. Use of a transformer for self-amplifying driving a charge-controlled switching element (20), wherein the transformer is a component of a switching device (100) and is designed and arranged in such a way that during a switch-on operation of the switching element (20) energy is transferred from a load current path (10) of the switching device (100) into a control current path (13) of the switching device, wherein a primary coil (42) of the transformer is connected to a load current terminal (22, 24) of the switching element (20), and wherein a secondary coil (44) of the transformer is connected to a control terminal (26) of the switching element (20),
**characterized in that**
the transformer is further designed and arranged to deactivate the secondary coil (44) of the transformer during a switch-off operation of the switching element (20).

## Revendications

1. Dispositif de commutation (100) comprenant :
- un élément de commutation (20) à commande de charge avec une première borne de courant de charge (22) pour l'alimentation d'un courant de charge à commuter, une deuxième borne de courant de charge (24) pour l'évacuation du courant de charge à commuter et une borne de commande (26) pour commander l'élément de commutation (20) au moyen d'un signal de commande, où les première et deuxième bornes de courant de charge (22, 24) sont intégrées dans un chemin de courant de charge (10) du dispositif de commutation (100) et où la borne de commande (26) est intégrée dans un chemin de courant de commande (13) du dispositif de commutation (100) ;
- une unité de commande (30) pour fournir le signal de commande ;
- un élément de couplage (40) pour la transmission séparée de manière galvanique d'énergie à partir du chemin de courant de charge (10) dans le chemin de courant de commande (13), où l'élément de couplage (40) est un transformateur avec une bobine primaire (42) et une bobine secondaire (44), où le transformateur est conçu et disposé de telle manière qu'il fournit une tension supplémentaire au niveau de la borne de commande (26) de l'élément de commutation (20) lors d'un processus de mise en marche de l'élément de commutation (20) afin d'augmenter ainsi le signal de commande,
**caractérisé en ce que** le transformateur est en outre conçu et disposé pour désactiver la bobine secondaire (44) du transformateur pendant un processus de mise à l'arrêt de l'élément de commutation (20).

2. Dispositif de commutation (100) selon la revendication 1,
dans lequel la bobine secondaire (44) est branchée entre l'unité de commande (30) et la borne de commande (26) de l'élément de commutation (20), et/ou
dans lequel la bobine secondaire (44) est branchée en série avec l'unité de commande (30) ou en parallèle par rapport à l'unité de commande (30).

3. Dispositif de commutation (100) selon l'une des revendications 1 à 2,
dans lequel la bobine primaire (42) du transformateur est reliée avec la première ou la deuxième borne de courant de charge (22, 24) de l'élément de commutation (20), et
dans lequel la bobine secondaire (44) du transformateur est reliée avec la borne de commande (26) de l'élément de commutation (20).

4. Dispositif de commutation (100) selon l'une des revendications précédentes, dans lequel l'unité de commande (30) comprend au moins une source de tension (31, 32) et/ou une commande de grille standard.

5. Dispositif de commutation (100) selon l'une des revendications précédentes, dans lequel l'unité de commande (30) est reliée galvaniquement avec la borne de commande (26) de l'élément de commutation (20).

6. Dispositif de commutation (100) selon l'une des revendications 1 à 3, comprenant en outre :
- une résistance de désactivation réglable ou un commutateur de désactivation (50) permettant de désactiver la bobine secondaire ; et/ou
une résistance d'enclenchement (52) externe qui est branchée entre la bobine secondaire (44) du transformateur et la borne de commande (26) de l'élément de commutation (20).

7. Dispositif de commutation (100) selon l'une des revendications 1 à 6, dans lequel le chemin du courant de commande (13) comprend un chemin d'enclenchement, par lequel il y a un enclenchement de l'élément de commutation (20), et un chemin d'arrêt par lequel il se produit une mise à l'arrêt de l'élément de commutation (20), où, de préférence, le chemin d'enclenchement comprend la bobine secondaire (44) du transformateur.

8. Dispositif de commutation (100) selon l'une des revendications précédentes, dans lequel l'élément de couplage (40) est un composant intégral d'un circuit imprimé.

9. Procédé de mise en marche d'auto-amplification d'un élément de commutation (20) à commande de charge, comprenant :
- la mise au point d'un élément de commutation (20) à commande de charge avec une première borne de courant de charge (22) pour l'alimentation d'un courant de charge à commuter, une deuxième borne de courant de charge (24) pour l'évacuation du courant de charge à commuter et une borne de commande (26) pour commander l'élément de commutation (20), où les première et deuxième bornes de courant de charge (22, 24) sont intégrées dans un chemin de courant de charge (10) et la borne de commande (26) est intégrée dans un chemin de courant de commande (13) ;
- la commande de l'élément de commutation (20) à commande de charge à l'aide de l'unité de commande (30) ; et
- la transmission séparée de manière galvanique d'énergie à partir du courant de charge (10) dans le chemin du courant de commande (13) pendant un processus de mise en marche de l'élément de commutation (20) à l'aide d'un élément de couplage (40, où l'élément de couplage (40) est un transformateur avec une bobine primaire (42) et une bobine secondaire (44), **caractérisé en ce que**
- la désactivation de la bobine secondaire (44) du transformateur pendant un processus de mise à l'arrêt de l'élément de commutation (20).

10. Utilisation d'un transformateur pour la mise en marche auto-amplifiée d'un élément de commutation (20) à commande de charge, dans laquelle le transformateur est un composant d'un dispositif de commutation (100) et est conçu et disposé de telle manière que, pendant un processus de mise en marche de l'élément de commutation (20), de l'énergie provenant d'un chemin de courant de charge (10) est transmis au dispositif de commutation (100) dans un chemin de courant de commande (13) du dispositif de commande, où une bobine primaire (42) du transformateur est reliée avec une borne courant de charge (22, 24) de l'élément de commutation (20) et où une bobine secondaire (44) du transformateur est reliée avec une borne de commande (26) de l'élément de commutation (20), **caractérisée en ce que** le transformateur est en outre conçu et disposé de telle manière pour désactiver la bobine secondaire (44) du transformateur pendant un processus de mise à l'arrêt de l'élément de commutation (20).
